# EUROPEAN PATENT SPECIFICATION

(11) **EP 3 403 886 B1**
(45) Date of publication and mention of the grant of the patent: **18.12.2019**
(21) Application number: 17171464.5
(22) Date of filing: 17.05.2017
(51) Int. Cl.: B60R 16/03

(54) **ON-BOARD MOTOR VEHICLE ELECTRICAL SYSTEM**
BORDEIGENES ELEKTRISCHES SYSTEM EINES KRAFTFAHRZEUGS
SYSTÈME ÉLECTRIQUE DE VÉHICULE AUTOMOBILE EMBARQUÉ

(43) Date of publication of application: 21.11.2018
(73) Proprietor: Mahle International GmbH, 70376 Stuttgart (DE)
(72) Inventor: BARUSCHKE, Wilhelm, 73117 Wangen (DE); GAUTSCH, Laurent, 67600 Mussig (FR); GRIES, Jean-Philippe, 68000 Colmar (FR); HEITZ, Jérôme, 68100 Mulhouse (FR); LUBRITZ, Oliver, 70197 Stuttgart (DE); TREIER, Joachim, 77728 Oppenau (DE)
(74) Representative: BRP Renaud & Partner mbB Rechtsanwälte Patentanwälte Steuerberater

(56) References cited:
- EP-A1- 2 711 248
- DE-B4-102004 046 275

## Description

The invention relates to an on-board motor vehicle electrical system comprising a first voltage supply system and comprising a second voltage supply system.

The prior art - for example EP 2 711 248 A1 or DE 10 2004 046 275 B4 - already discloses on-board motor vehicle electrical systems which have a first voltage supply system and a second voltage supply system. The first voltage supply system is supplied by means of a first voltage source with a relatively low voltage, and the second voltage supply system is supplied by means of a second voltage source with a relatively high voltage. By way of example, the voltages can be 12 V and 24 V or 12 V and 48 V respectively. The second voltage supply system is used to supply loads such as, for example, heaters, pumps, compressors or else generators, and the first voltage supply system is used to drive the respective loads.

In order to prevent damage to the electronics and also to the loads as a result of a short circuit, it is necessary to DC-isolate the first voltage supply system and the second voltage supply system from one another. DC-isolated detection of electrical measurement values - in particular of the current - from the loads is not possible in conventional on-board motor vehicle electrical systems and therefore it is also more difficult to drive the said loads from the first voltage supply system.

The object of the invention is therefore to provide an on-board motor vehicle electrical system comprising a first voltage supply system and comprising a second voltage supply system, wherein a DC-isolated detection of a current flowing through a load is possible in the on-board motor vehicle electrical system, and wherein the load can be driven more accurately as a result.

According to the invention, this object is achieved by the subject matter of independent Claim 1. Advantageous embodiments are the subject matter of the dependent claims.

The present invention is based on the general idea of detecting a current flowing through a load in an on-board motor vehicle electrical system comprising a first voltage supply system and comprising a second voltage supply system in a DC-isolated manner. In the on-board motor vehicle electrical system, the first voltage supply system has a first voltage source with a relatively low voltage, and the second voltage supply system has a second voltage source with a relatively high voltage, wherein the magnitude of the relatively low voltage is below the magnitude of the relatively high voltage. The first voltage supply system and the second voltage supply system are DC-isolated from one another and connected to one another in a signal-transmitting manner by at least one coupling element. The second voltage supply system also has at least one electrical switching element, which is electrically connected to the respective coupling element, for a load, wherein the on-board motor vehicle electrical system has a current measuring arrangement for measuring a current flowing to the load. According to the invention, the current measuring arrangement comprises at least one Hall sensor which is electrically connected to the first voltage source. The Hall sensor is therefore supplied with the voltage by means of the first voltage supply system and can detect the current flowing through the load in the second voltage supply system in a DC-isolated manner. In this way, the first voltage supply system and the second voltage supply system are DC-isolated from one another in a standard-conforming manner and, nevertheless, the load can be accurately driven.

According to the invention, the first voltage source with the relatively low voltage supplies the first voltage supply system, and the second voltage source with the relatively high voltage supplies the second voltage supply system. In this case, a relatively low voltage is defined as a voltage of which the magnitude is below the magnitude of the relatively high voltage. Therefore, by way of example, the first voltage supply system and the second voltage supply system can have voltages of 12 V and 24 V or 12 V and 48 V respectively. In this case, the second voltage supply system with a relatively high voltage supplies at least one load which has a high energy requirement and cannot be supplied by means of the first voltage supply system with a relatively low voltage. The load can be, for example, an electric motor, a generator, an electric heater, a compressor, an electric pump, an electric power steering arrangement, a roll stabilization arrangement, an electric fan motor, an electrical converter or else a battery. The first voltage supply system is used for external driving by means of an LIN interface (Local Interconnect Network interface).

The first voltage supply system and the second voltage supply system are DC-isolated from one another and connected to one another in a signal-transmitting manner by at least one coupling element, so that the load which is electrically supplied by the second voltage source can be driven from the first voltage supply system. The coupling element can be, for example, a diode or an isolation amplifier, such as an optocoupler for example. In this case, the respective load is operated by the electrical switching element which is connected to the first voltage supply system by the coupling element.

According to the invention, the current flowing through the load is detected by the Hall sensor. The Hall sensor detects an electromagnetic field on a line, which electromagnetic field correlates to the current flowing in the said line, so that ultimately the measurement data which is detected by the Hall sensor also correlates to the current flowing in the line. According to the invention, the Hall sensor is supplied with power by the first voltage source with the relatively low voltage and therefore interacts only electromagnetically with the second voltage supply system. Therefore, the Hall sensor is DC-isolated from the second voltage supply system and does not influence the current flowing in the second voltage supply system. In this way, more accurate measurement results are achieved and standard-conforming DC-isolation of the first voltage supply system from the second voltage supply system is possible. In addition, the development of heat on the current measuring arrangement is also reduced and the individual electrical components of the first voltage supply system and of the second voltage supply system are advantageously protected against overheating.

It is advantageously provided that the Hall sensor is arranged on a switch conductor, which electrically connects the respective coupling element and the respective switching element, so as to have an electromagnetic effect. As an alternative, the Hall sensor can be arranged on a load conductor, which leads from the respective switching element to the respective load, so as to have an electromagnetic effect. The current flowing through the switch conductor or the load conductor generates an electromagnetic field around the switch conductor and around the load conductor, it being possible for the said electromagnetic field to be detected by the Hall sensor. In this case, the electromagnetic field generated correlates to the current in the switch conductor and in the load conductor, so that the current flowing to the load can be detected by the Hall sensor. In this case, the Hall sensor interacts only electromagnetically with the switch conductor and with the load conductor, so that the Hall sensor which is supplied by the first voltage supply system remains DC-isolated from the second voltage supply system.

The strength of the electromagnetic effect of the Hall sensor and of the switch conductor or of the load conductor depends substantially on the arrangement of the Hall sensor on the switch conductor or on the load conductor. In order to amplify the electromagnetic effect, the Hall sensor can be arranged directly on the switch conductor or on the load conductor. If, for example, the switch conductor and the load conductor are arranged - for example are printed or etched - on a control board, the Hall sensor can be secured on the control board above or to the side of the switch conductor or the load conductor. The Hall sensor can also be secured on the switch conductor or on the load conductor which are designed, for example, as feed cables or as cable pieces which are soldered onto the control board.

It is advantageously provided that the current measuring arrangement has an iron core. The iron core is arranged on the Hall sensor in such a way that the electromagnetic effect of the Hall sensor with the switch conductor or with the load conductor is amplified. Owing to the iron core, the electromagnetic field around the switch conductor and around the load conductor is amplified and the Hall sensor can also accurately detect relatively low currents. The accuracy of the current measurement and also of driving of the load are increased as a result.

In order to be able to evaluate measurement data from the Hall sensor, it is advantageously provided that the current measuring arrangement has a measuring unit. The measuring unit can evaluate the measurement data which is detected by the Hall sensor and pass on the said measurement data, for example, to a drive arrangement of the load.

It is advantageously provided that the measuring unit is electrically connected to the switch conductor or to the load conductor. An electrical connection to the switch conductor or to the load conductor allows the measuring unit to be supplied by the second voltage source with the relatively high voltage. If the second voltage supply system is not supplied with the voltage, the measuring unit is also disconnected. As a result, energy can be saved and the risk of a short circuit can be reduced.

In a development of the current measuring arrangement according to the invention, it is provided that the Hall sensor is arranged on the measuring unit so as to have an electromagnetic effect. Therefore, the measuring unit can be coupled into the second voltage supply system and the current flowing through the measuring unit can be detected at the measuring unit. The measuring unit and the Hall sensor can advantageously be embodied as a complete unit and as a result the space requirement for the current measuring arrangement can be reduced.

In order to be able to drive the load, it is provided according to the invention that the first voltage supply system has a control apparatus which is electrically connected to the first voltage source and is connected to the current measuring arrangement in a signal-transmitting manner. Therefore, the measurement data which is detected by the current measuring arrangement can be transmitted to the control apparatus in a DC-isolated manner and the load can be controlled in accordance with the detected measurement data. The control apparatus can have, for example, a microcontroller for this purpose.

It is advantageously provided that the first voltage supply system has a voltage measuring arrangement. The voltage measuring arrangement can detect the voltage in the first voltage supply system and pass it on, for example, to the control apparatus for further evaluation.

In order to improve the DC-isolation of the first voltage supply system and the second voltage supply system, it is provided that the first voltage supply system has a first earth connection and the second voltage supply system has a second earth connection, the said first earth connection and the said second earth connection being DC-isolated from one another. If, for example, the second voltage supply system is decoupled from the first voltage supply system, the first voltage supply system and the second voltage supply system each have an earth connection and the risk of a short-circuit is minimized.

In an advantageous development of the solution according to the invention, it is provided that at least one of the respective coupling elements has a diode. It is further provided that at least one of the respective switching elements has a field-effect transistor, preferably a metal-oxide-semiconductor field-effect transistor, or a circuit breaker.

Further important features and advantages of the invention can be gathered from the dependent claims, from the drawings and from the associated description of the figures with reference to the drawings.

It goes without saying that the features which are mentioned above and those still to be explained below can be used not only in the respectively specified combination but rather also in other combinations or on their own, without departing from the scope of the present invention.

Preferred exemplary embodiments of the invention are shown in the drawings and will be explained in greater detail in the following description, with identical reference symbols relating to identical or similar or functionally identical components.

In the drawings
- Fig. 1: schematically shows a view of an on-board motor vehicle electrical system according to the invention comprising a first and comprising a second voltage supply system;
- Fig. 2: schematically shows a view of a control board comprising a current measuring arrangement which is arranged on a switch conductor;
- Fig. 3: schematically shows a view of a control board comprising a current measuring arrangement which is arranged on a load conductor;
- Fig. 4: schematically shows a side view of the control board shown in Fig. 3 comprising a current measuring arrangement;
- Fig. 5: schematically shows a side view of a control board comprising a Hall sensor;
- Fig. 6: schematically shows a side view of a control board comprising a Hall sensor and comprising an iron core.

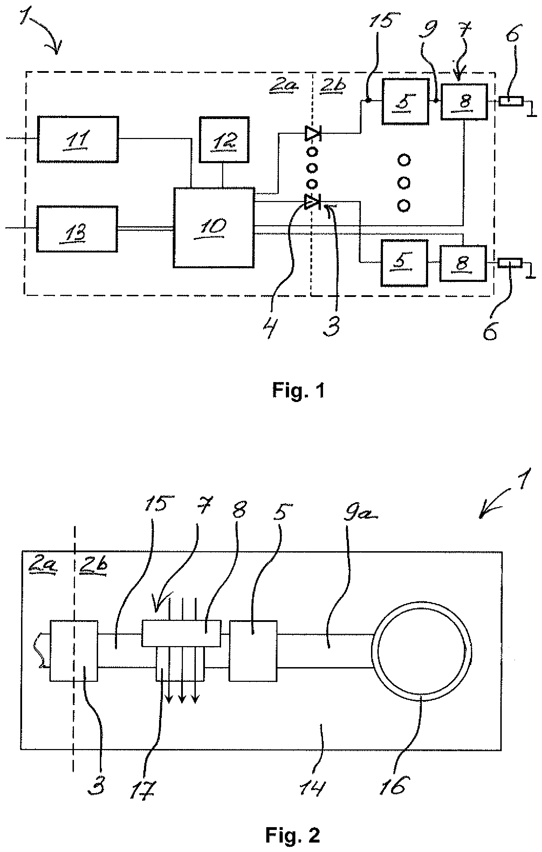

Fig. 1 shows a schematic view of an on-board motor vehicle electrical system 1 according to the invention comprising a first voltage supply system 2a and comprising a second voltage supply system 2b. In the on-board motor vehicle electrical system 1, the first voltage supply system 2a is supplied by a first voltage source with a relatively low voltage, and the second voltage supply system 2b is supplied by a second voltage source with a relatively high voltage. By way of example, the voltages in the first voltage supply system 2a and in the second voltage supply system 2b can be 12 V and 48 volts respectively. The first voltage supply system 2a and the second voltage supply system 2b are DC-isolated from one another and connected to one another in a signal-transmitting manner by a plurality of coupling elements 3 - here diodes 4. The second voltage supply system 2b has a plurality of switching elements 5, which are electrically connected to the respective coupling element 3, for the load 6. The switching elements 5 can be, for example, field-effect transistors, preferably metal-oxide-semiconductor field-effect transistors, or circuit breakers. The loads 6 can be, for example, an electric motor, a generator, an electric heater, a compressor, an electric pump, an electric power steering arrangement, a roll stabilization arrangement, an electric fan motor, an electrical converter or else a battery. The respective load 6 is operated by the electrical switching element 5 which is connected to the first voltage supply system 2a by the respective coupling element 3.

The on-board motor vehicle electrical system 1 furthermore has a current measuring arrangement 7 which comprises a plurality of Hall sensors 8. The respective Hall sensors 8 are electrically connected to the first voltage supply system 2a and are electrically isolated from the second voltage supply system 2b. In this exemplary embodiment, the Hall sensors 8 are arranged on a load conductor 9, which leads from the respective switching element 5 to the respective load 6, so as to have an electromagnetic effect. The current flowing through the respective load conductor 9 generates an electromagnetic field around the respective load conductor 9, it being possible for the said electromagnetic field to be detected by the respective Hall sensor 8. In this case, the electromagnetic field generated correlates to the current in the load conductor 9, so that the current flowing to the load 6 can be detected by the Hall sensor 8. In this case, the Hall sensor 8 interacts only electromagnetically with the load conductor 9, so that the Hall sensor 8 which is supplied by the first voltage supply system 2a is DC-isolated from the second voltage supply system 2b.

In order to be able to drive the load 6, the first voltage supply system 2a has a control apparatus 10 which is connected to the current measuring arrangement 7 in a signal-transmitting manner. Therefore, the measurement data which is detected by the current measuring arrangement 7 can be transmitted to the control apparatus 10 and the load 6 can be driven in accordance with the detected measurement data. The control apparatus 10 is supplied with the voltage by a voltage converter 11 - here a voltage converter of from 12 V to 5 V for example - and can be, for example, a microcontroller. In addition, the first voltage supply system 2a also has a voltage measuring arrangement 12 by which the voltage in the first voltage supply system 2a can be detected and passed on, for example, to the control apparatus 10 for further evaluation. The first voltage supply system 2a furthermore has an LIN connection point 13 which is connected to the control apparatus 10 in a signal-transmitting manner.

In order to improve the DC-isolation of the first voltage supply system 2a and the second voltage supply system 2b, the first voltage supply system 2a can have a first earth connection and the second voltage supply system 2b can have a second earth connection, the said first earth connection and the said second earth connection being DC-isolated from one another.

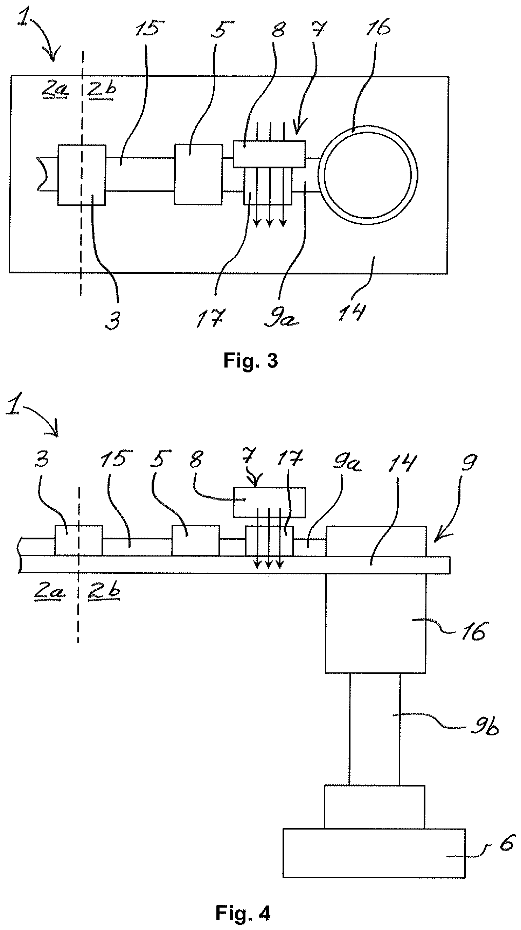

Fig. 2 shows a schematic view of a control board 14, wherein the current measuring arrangement 7, as an alternative to Fig. 1, is arranged on a switch conductor 15. Fig. 3 shows a schematic view and Fig. 4 shows a schematic side view of the control board 14 comprising the current measuring arrangement 7 which is arranged on the load conductor 9. Here, the load conductor 9 is divided into a board piece 9a and into a supply cable 9b by a connection socket 16. In this exemplary embodiment, the current measuring arrangement 7 has a measuring unit 17 which evaluates and passes on measurement data which is detected by the Hall sensor 8. The measuring unit 17 is electrically connected to the board piece 9a of the load conductor 9, and the Hall sensor 8 is arranged on the measuring unit 17 so as to have an electromagnetic effect. The Hall sensor 8 detects the current which flows through the measuring unit 17 which is connected into the second voltage supply system 2b. In this case, the Hall sensor 8 is supplied by the first voltage supply system 2a and is connected to the measuring unit 17 only in a signal-transmitting manner.

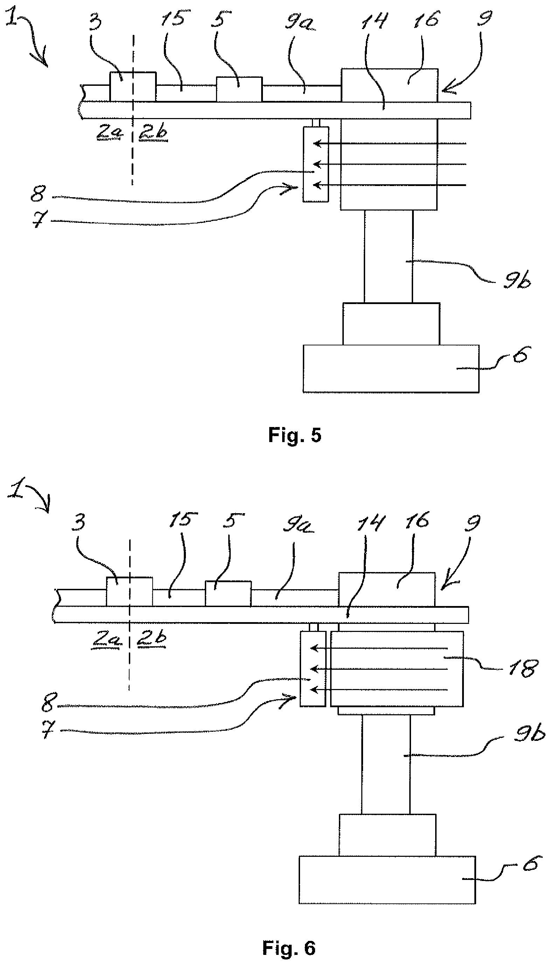

Fig. 5 shows a schematic side view of the control board 14, wherein the Hall sensor 8 is arranged on the connection socket 16 of the load conductor 9 so as to have an electromagnetic effect. In order to avoid unnecessary cabling between the Hall sensor 8 and the control board 14, the Hall sensor 8 is secured directly to the control board 14, wherein the Hall sensor 8 is nevertheless arranged in an electromagnetic field which is generated around the connection socket 16.

Fig. 6 shows a schematic side view of the control board 14 comprising the Hall sensor 8 and comprising an iron core 18. The iron core 18 is arranged on the Hall sensor 8 in such a way that the electromagnetic effect of the Hall sensor 8 with the load conductor 9 is amplified. Owing to the iron core 18, the electromagnetic field around the load conductor 9 is amplified and the Hall sensor 8 can also accurately detect relatively low currents. The iron core 18 is of substantially annular design and is arranged around the connection socket 16 of the load conductor 9. The iron core 18 of annular design can increase the electromagnetic field around the connection socket 16 in a particularly effective manner.

The on-board motor vehicle electrical system 1 according to the invention allows standard-conforming DC-isolation of the first voltage supply system 2a and of the second voltage supply system 2b from one another and accurate and DC-isolated detection of the current flowing across the load 6. This advantageously allows more accurate driving of the load 6 and minimizes the risk of a short circuit.

## Claims

1. On-board motor vehicle electrical system (1) comprising a first voltage supply system (2a) and comprising a second voltage supply system (2b),
- wherein the first voltage supply system (2a) has a first voltage source with a relatively low voltage, and the second voltage supply system (2b) has a second voltage source with a relatively high voltage,
- wherein the first voltage supply system (2a) and the second voltage supply system (2b) are DC-isolated from one another and connected to one another in a signal-transmitting manner by at least one coupling element (3),
- wherein the second voltage supply system (2b) has at least one electrical switching element (5), which is electrically connected to the respective coupling element (3), for a load (6), and
- wherein the on-board motor vehicle electrical system (1) has a current measuring arrangement (7) for measuring a current flowing to the load (6),
**characterized**
**in that** the current measuring arrangement (7) comprises at least one Hall sensor (8) which is electrically connected to the first voltage source.

2. On-board motor vehicle electrical system (1) according to Claim 1,
**characterized**
**in that** the Hall sensor (8) is arranged on a switch conductor (15), which electrically connects the respective coupling element (3) and the respective switching element (5), so as to have an electromagnetic effect.

3. On-board motor vehicle electrical system (1) according to Claim 1,
**characterized**
**in that** the Hall sensor (8) is arranged on a load conductor (9), which leads from the respective switching element (5) to the respective load (6), so as to have an electromagnetic effect.

4. On-board motor vehicle electrical system according to Claim 2 or 3,
**characterized**
**in that** the current measuring arrangement (7) has an iron core (18), and in that the iron core (18) is arranged on the Hall sensor (8) in such a way that an electromagnetic effect of the Hall sensor (8) with the switch conductor (15) or with the load conductor (9) is amplified.

5. On-board motor vehicle electrical system (1) according to one of the preceding claims,
**characterized**
**in that** the current measuring arrangement (7) has a measuring unit (17) for evaluating measurement data from the Hall sensor (8).

6. On-board motor vehicle electrical system (1) according to Claim 5,
**characterized**
**in that** the measuring unit (17) is electrically connected to the switch conductor (15) or to the load conductor (9).

7. On-board motor vehicle electrical system (1) according to Claim 5 or 6,
**characterized**
**in that** the Hall sensor (8) is arranged on the measuring unit (17) so as to have an electromagnetic effect.

8. On-board motor vehicle electrical system (1) according to one of the preceding claims,
**characterized**
**in that** the first voltage supply system (2a) has a control apparatus (10) which is electrically connected to the first voltage source and is connected to the current measuring arrangement (7) in a signal-transmitting manner.

9. On-board motor vehicle electrical system (1) according to Claim 8,
**characterized**
**in that** the control apparatus (10) has a microcontroller.

10. On-board motor vehicle electrical system (1) according to one of the preceding claims,
**characterized**
**in that** the first voltage supply system (2a) has a voltage measuring arrangement (12).

11. On-board motor vehicle electrical system (1) according to one of the preceding claims,
**characterized**
**in that** the first voltage supply system (2a) has a first earth connection and the second voltage supply system (2b) has a second earth connection, the said first earth connection and the said second earth connection being DC-isolated from one another.

12. On-board motor vehicle electrical system (1) according to one of the preceding claims,
**characterized**
**in that** at least one of the respective coupling elements (3) has a diode (4).

13. On-board motor vehicle electrical system (1) according to one of the preceding claims,
**characterized**
**in that** at least one of the respective switching elements (5) has a field-effect transistor, preferably a metal-oxide-semiconductor field-effect transistor, or a circuit breaker.

## Patentansprüche

1. Elektrisches Kraftfahrzeug-Bordsystem (1), das ein erstes Spannungsversorgungssystem (2a) umfasst, und ein zweites Spannungsversorgungssystem (2b) umfasst,
- wobei das erste Spannungsversorgungssystem (2a) eine erste Spannungsquelle mit einer relativ niedrigen Spannung aufweist, und das zweite Spannungsversorgungssystem (2b) eine zweite Spannungsquelle mit einer relativ hohen Spannung aufweist,
- wobei das erste Spannungsversorgungssystem (2a) und das zweite Spannungsversorgungssystem (2b) voneinander galvanisch isoliert sind und durch mindestens ein Kopplungselement (3) signalübertragend miteinander verbunden sind,
- wobei das zweite Spannungsversorgungssystem (2b) mindestens ein elektrisches Umschaltelement (5) für eine Last (6) aufweist, das elektrisch mit dem jeweiligen Kopplungselement (3) gekoppelt ist, und
- wobei das elektrische Kraftfahrzeug-Bordsystem (1) eine Strommessanordnung (7) zum Messen eines Stroms, der zu der Last (6) fließt, aufweist,
**dadurch gekennzeichnet,**
**dass** die Strommessanordnung (7) mindestens einen Hallsensor (8), der elektrisch mit der ersten Spannungsquelle verbunden ist, umfasst.

2. Elektrisches Kraftfahrzeug-Bordsystem (1) nach Anspruch 1,
**dadurch gekennzeichnet,**
**dass** der Hallsensor (8) auf einem Umschaltleiter (15), der das jeweilige Kopplungselement (3) und das jeweilige Umschaltelement (5) elektrisch verbindet, derart angeordnet ist, dass sie elektromagnetisch zusammenwirken.

3. Elektrisches Kraftfahrzeug-Bordsystem (1) nach Anspruch 1,
**dadurch gekennzeichnet,**
**dass** der Hallsensor (8) auf einem Lastleiter (9), der von dem jeweiligen Umschaltelement (5) zu der jeweiligen Last (6) führt, derart angeordnet ist, dass sie elektromagnetisch zusammenwirken.

4. Elektrisches Kraftfahrzeug-Bordsystem (1) nach Anspruch 2 oder 3,
**dadurch gekennzeichnet,**
**dass** die Strommessanordnung (7) einen Eisenkern (18) aufweist, und dass der Eisenkern (18) auf dem Hallsensor (8) derart angeordnet ist, dass eine elektromagnetische Wirkung des Hallsensors (8) mit dem Umschaltleiter (15) oder mit dem Lastleiter (9) verstärkt ist.

5. Elektrisches Kraftfahrzeug-Bordsystem (1) nach einem der vorstehenden Ansprüche,
**dadurch gekennzeichnet,**
**dass** die Strommessanordnung (7) eine Messeinheit (17) zum Bewerten von Messdaten von dem Hallsensor (8) aufweist.

6. Elektrisches Kraftfahrzeug-Bordsystem (1) nach Anspruch 5,
**dadurch gekennzeichnet,**
**dass** die Messeinheit (17) elektrisch mit dem Umschaltleiter (15) oder mit dem Lastleiter (9) verbunden ist.

7. Elektrisches Kraftfahrzeug-Bordsystem (1) nach Anspruch 5 oder 6,
**dadurch gekennzeichnet,**
**dass** der Hallsensor (8) auf der Messeinheit (17) derart angeordnet ist, dass er mit dieser elektromagnetisch zusammenwirkt.

8. Elektrisches Kraftfahrzeug-Bordsystem (1) nach einem der vorstehenden Ansprüche,
**dadurch gekennzeichnet,**
**dass** das erste Spannungsversorgungssystem (2a) eine Steuereinrichtung (10) aufweist, die elektrisch mit der ersten Spannungsquelle verbunden ist, und mit der Strommessanordnung (7) signalübertragend verbunden ist.

9. Elektrisches Kraftfahrzeug-Bordsystem (1) nach Anspruch 8,
**dadurch gekennzeichnet,**
**dass** die Steuereinrichtung (10) einen Mikrocontroller aufweist.

10. Elektrisches Kraftfahrzeug-Bordsystem (1) nach einem der vorstehenden Ansprüche,
**dadurch gekennzeichnet,**
**dass** das erste Spannungsversorgungssystem (2a) eine Spannungsmesseinrichtung (12) aufweist.

11. Elektrisches Kraftfahrzeug-Bordsystem (1) nach einem der vorstehenden Ansprüche,
**dadurch gekennzeichnet,**
**dass** das erste Spannungsversorgungssystem (2a) einen ersten Masseanschluss aufweist, und dass das zweite Spannungsversorgungssystem (2b) einen zweiten Masseanschluss aufweist, wobei der erste Masseanschluss und der zweite Masseanschluss voneinander galvanisch isoliert sind.

12. Elektrisches Kraftfahrzeug-Bordsystem (1) nach einem der vorstehenden Ansprüche,
**dadurch gekennzeichnet,**
**dass** mindestens eines der jeweiligen Kopplungselemente (3) eine Diode (4) aufweist.

13. Elektrisches Kraftfahrzeug-Bordsystem (1) nach einem der vorstehenden Ansprüche,
**dadurch gekennzeichnet,**
**dass** mindestens eines der jeweiligen Umschaltelemente (5) einen Feldeffekttransistor, bevorzugt einen Metalloxid-Halbleiter-Feldeffekttransistor oder einen Leistungsschalter aufweist.

## Revendications

1. Système électrique embarqué (1) pour véhicule automobile comprenant un premier système d'alimentation en tension (2a) et comprenant un second système d'alimentation en tension (2b),
- dans lequel le premier système d'alimentation en tension (2a) présente une première source de tension avec une tension relativement basse et le second système d'alimentation en tension (2b) présente une seconde source de tension avec une tension relativement élevée,
- dans lequel le premier système d'alimentation en tension (2a) et le second système d'alimentation en tension (2b) sont isolés l'un de l'autre en courant continu et sont reliés l'un à l'autre de manière à transmettre le signal par au moins un élément de couplage (3),
- dans lequel le second système d'alimentation en tension (2b) présente au moins un élément de commutation (5) électrique, qui est électriquement relié à l'élément de couplage (3) respectif, pour une charge (6), et
- dans lequel le système électrique embarqué (1) pour véhicule automobile présente un aménagement de mesure de courant (7) pour mesurer un courant s'écoulant vers la charge (6),
**caractérisé**
**en ce que** l'aménagement de mesure de courant (7) comprend au moins un capteur à effet Hall (8) qui est électriquement relié à la première source de tension.

2. Système électrique embarqué (1) pour véhicule automobile selon la revendication 1,
**caractérisé**
**en ce que** le capteur à effet Hall (8) est agencé sur un conducteur de commutateur (15), qui relie électriquement l'élément de couplage (3) respectif et l'élément de commutation (5) respectif, afin de présenter un effet électromagnétique.

3. Système électrique embarqué (1) pour véhicule automobile selon la revendication 1,
**caractérisé**
**en ce que** le capteur à effet Hall (8) est agencé sur un conducteur de charge (9), qui mène de l'élément de commutation (5) respectif à la charge respective (6), afin de présenter un effet électromagnétique.

4. Système électrique embarqué pour véhicule automobile selon la revendication 2 ou 3,
**caractérisé**
**en ce que** l'aménagement de mesure de courant (7) présente un noyau de fer (18), et **en ce que** le noyau de fer (18) est agencé sur le capteur à effet Hall (8) d'une telle façon qu'un effet électromagnétique du capteur à effet Hall (8) avec le conducteur de commutateur (15) ou avec le conducteur de charge (9) est amplifié.

5. Système électrique embarqué (1) pour véhicule automobile selon l'une des revendications précédentes,
**caractérisé**
**en ce que** l'aménagement de mesure de courant (7) présente une unité de mesure (17) pour évaluer des données de mesure en provenance du capteur à effet Hall (8).

6. Système électrique embarqué (1) pour véhicule automobile selon la revendication 5,
**caractérisé**
**en ce que** l'unité de mesure (17) est électriquement reliée au conducteur de commutateur (15) ou au conducteur de charge (9).

7. Système électrique embarqué (1) pour véhicule automobile selon la revendication 5 ou 6,
**caractérisé**
**en ce que** le capteur à effet Hall (8) est agencé sur l'unité de mesure (17) afin de présenter un effet électromagnétique.

8. Système électrique embarqué (1) pour véhicule automobile selon l'une des revendications précédentes,
**caractérisé**
**en ce que** le premier système d'alimentation en tension (2a) présente un dispositif de commande (10) qui est électriquement relié à la première source de tension et qui est relié à l'aménagement de mesure de courant (7) de manière à transmettre le signal.

9. Système électrique embarqué (1) pour véhicule automobile selon la revendication 8,
**caractérisé**
**en ce que** le dispositif de commande (10) présente une micro-unité de commande.

10. Système électrique embarqué (1) pour véhicule automobile selon l'une des revendications précédentes,
**caractérisé**
**en ce que** le premier système d'alimentation en tension (2a) présente un aménagement de mesure de tension (12).

11. Système électrique embarqué (1) pour véhicule automobile selon l'une des revendications précédentes,
**caractérisé**
**en ce que** le premier système d'alimentation en tension (2a) présente une première liaison à la terre et le second système d'alimentation en tension (2b) présente une seconde liaison à la terre, ladite première liaison à la terre et ladite seconde liaison à la terre étant isolées l'une de l'autre en courant continu.

12. Système électrique embarqué (1) pour véhicule automobile selon l'une des revendications précédentes,
**caractérisé**
**en ce qu'**au moins un des éléments de couplage (3) respectifs présente une diode (4).

13. Système électrique embarqué (1) pour véhicule automobile selon l'une des revendications précédentes,
**caractérisé**
**en ce qu'**au moins un des éléments de commutation (5) respectifs présente un transistor à effet de champ, de préférence un transistor à effet de champ à semiconducteur à oxyde métallique, ou un disjoncteur.
